# EUROPEAN PATENT SPECIFICATION

(11) **EP 1 868 255 B1**
(45) Date of publication and mention of the grant of the patent: **19.10.2011**
(21) Application number: 06012336.1
(22) Date of filing: 14.06.2006
(51) Int. Cl.: H01L 51/00

(54) **Method for surface processing in a vacuum environment**
Methode zur Oberflächenbehandlung im Vakuum
Procédé destiné au traitement de surface sous vide

(43) Date of publication of application: 19.12.2007
(73) Proprietor: Novaled AG, 01307 Dresden (DE)
(72) Inventor: Romainczyk, Tilmann,, 01099 Dresden (DE); Gross, Harald, 01109 Dresden (DE)
(74) Representative: Bittner, Thomas L.

(56) References cited:
- WO-A-99/59184
- WO-A-2006/072021
- US-A- 4 908 226
- US-A1- 2002 061 418
- US-A1- 2004 161 708
- US-A1- 2005 016 462
- MELNGAILIS J: "Focused ion beam technology and applications" JOURNAL OF VACUUM SCIENCE & TECHNOLOGY B (MICROELECTRONICS PROCESSING AND PHENOMENA) USA, vol. 5, no. 2, March 1987 (1987-03), pages 469-495, XP008071146 ISSN: 0734-211X
- VASILE M J ET AL: "FOCUSED ION BEAM STIMULATED DEPOSITION OF ORGANIC COMPOUNDS" JOURNAL OF VACUUM SCIENCE AND TECHNOLOGY: PART B, AVS / AIP, MELVILLE, NEW YORK, NY, US, vol. 7, no. 6, 1 November 1989 (1989-11-01), pages 1954-1958, XP000249749 ISSN: 1071-1023
- J.B. FENN ET AL.: "Electrospray ionization - principles and practice" MASS SPECTROMETRY REVIEWS, vol. 9, 1990, pages 37-70, XP002406702

## Description

The invention refers to a method for surface processing in a vacuum environment.

### Background of the invention

So called small molecules are utilized to fabricate organic light emitting diodes (OLEDs), organic solar cells or other organic electronics. These molecules are highly sensitive to oxygen and moisture compared to polymers that represent the only other type of molecules for OLEDs. Therefore conventional processing methods of semiconductor devices are not suitable for manufacturing of displays or other products, which require patterning of layers of small molecules.

The state-of-the-art technology to selectively deposit red, green and blue organic emitter materials of small molecules onto e.g. active matrix displays is shadow masking. Different thermal expansion coefficients of mask materials and display substrates as well as the thermal expansion of the mask during processing limit the display size, e.g. to 15 inches currently. Furthermore, high mask costs and precision alignment procedures are adversarial for mass production. Moreover a minimum distance between shadow mask and substrate is necessary to prevent mechanical damages, but leads to deposition at undesired places on the substrate (M. Shtein et al.: "Micropatterning of small molecular weight organic semiconductor thin films using organic vapor phase deposition"; J. Appl. Phys., Vol.93, No.7, April 2003, p.4005-4016). In addition, the uniformity at edges and corners of each pixel is rather poor due to mask insufficiencies. Another disadvantage of shadow masking is inevitable regular cleaning of the masks due to the built-up of deposited material.

Laser induced thermal imaging (LITI) has been developed as an alternative to shadow masking. However this technology requires a donor film of organic molecules and a highly sophisticated laser exposure system. It has not been proven in mass production, yet, mainly because of low throughput of the laser scanning and entailing costs.

Other methods like ion beam lithography (Qing Ji: "Maskless, resistless ion beam lithography processes", dissertation, Lawrence Berkeley National Laboratory, University of California, 2003; R. Saf et al.: "Thin organic films by atmospheric-pressure ion deposition", nature materials, Vol.3, May 2004, p. 323-329) are still in the research phase and have not developed beyond laboratory stage. In case of ion beam scanning methods the lack of throughput next to other technological hurdles prevents the introduction into mass production.

Document US 2005/0016462 A1 discloses a film forming method in which a film is formed by evaporating an organic compound material from a deposition source in the film forming chamber, minute amounts of gas which comprises smaller particles than particles of the organic compound material.

A summary of technologies in the field of focused ion beam fabrication is provided by Melngailis (Focused ion beam technology and review, J. Vac. Sci. Technol. B 5(2), March 1987, XP8071146).

Document DE 196 41 584 C1 discloses an assembly and a method for depositing a thin layer on a substrate. A focus tool or filter for focusing an ion shower is used in the device and the method.

Document US 2006/0037701 A1 refers to an apparatus comprising an upper electrode and a lower electrode for supporting a wafer deposit opposite each other within a process chamber. A first RF power supply configured to apply a first RF power having a relatively higher frequency is connected to the upper electrode. A second RF power supply configured to apply a second RF power having a relatively lower frequency is connected to the lower electrode. A variable DC power supply is connected to the upper electrode. A process gas is supplied into the process chamber while any one of application voltage, application current and application power from the variable DC power supply to the upper electrode is controlled, to generate plasma of the process gas so as to perform plasma etching.

In the document US 4,983,253 an etching process and an apparatus employing a magnetic enhancement means and a substantially pure molecular bromine plasma in order to perform in a desired manner for a number of applications requiring etching of single-crystal and polycristalline silicon are disclosed.

### Summary of the invention

It is the object of the invention to provide a method for surface processing in a vacuum environment, the method providing micro surface processing without using a mask.

According to the invention a method for vacuum deposition of a thin layer on a substrate is provided as per claim 1.

Compared to the prior art, there is the option to utilize at least one of already existing patterns on the substrate and pattern(s) of a master for self-alignment of the ionized particles according to the field component(s). Further, by the method according to the invention a maskless deposition method is provided especially for, but not limited to active and passive matrix color displays. The known shadow mask technology and its inherent challenges, especially for large displays are circumvented. In a first order approximation the method is independent of display size. The method is suitable, but not limited to display production. It can be useful for any process, where a spatial separation of material to be deposited is needed. Because the ion trajectories are based on the equipotential lines, also odd-shaped geometries, even three-dimensional surfaces could be coated, e.g. sidewalls of structures with high aspect ratios.

For the proposed surface processing by means of the ionized particles, a micro-field is generated which is provided to interact with the ionized particles in a micro environment of the substrate surface. The micro field is provided in addition to a macro field. The macro field is used to accelerate the ionized particles through the vacuum environment, thereby leading (bringing) the ionized particles into the vicinity of the surface, namely into the micro environment of the surface of the substrate where the micro filed is establishing its guiding effect to the ionized particles. The macro field is to be applied like in known ion beam systems. Typically the macro field is generated by supplying a voltage difference between a source and the substrate. As a good estimation, an effective range of the micro field may be defined by an intensity drop of a micro field component (I) characterizing the micro field to 1/e (I* 1/e).

In a preferred embodiment, the first field component comprises at least one of a first attractive potential, a first repellant potential, and a focusing magnetic force.

According to a further embodiment, the step of providing the micro field further comprises providing the micro field by a micro field generator separated from the substrate.

In still a further embodiment, the step of providing the micro field generator separated from the substrate comprises providing a magneto-static field generator.

According to a preferred embodiment, the step of providing the magneto-static field generator comprises providing at least one of a permanent magnetic field generator and an electrically magnetized field generator.

In another preferred embodiment, the step of providing the micro field further comprises applying an electric voltage to at least one of the substrate and the field generator separated from the substrate.

In a preferred embodiment, the step of providing ionized particles of the first material comprises providing the first material as a dopant material and depositing the dopant material in a matrix material on the surface.

According to a further embodiment, the step of depositing the dopant material in the matrix material comprises co-evaporating the dopant material and the matrix material.

In a further embodiment, the step of providing the dopant material comprises providing the dopant material as at least one of a dye material and an electric dopant material improving electric conductivity of the matrix material.

In still a further embodiment, the method further comprises steps of: providing ionized particles of a second material in the vacuum environment; bringing the ionized particles of the second material into the micro environment of the surface of the substrate through the vacuum environment; providing the micro field with a second field component in the micro environment of the surface, wherein the second field component comprises at least one of an electric field component and a magnetic field component and wherein an interaction between the second field component and the ionized particles of the second material is limited to the micro environment of the surface; and guiding in the micro environment the ionized particles of the second material by the second field component to the surface of the substrate, thereby bringing the ionized particles of the second material into contact with the surface of the substrate in at least one of the predefined locations and additional predefined locations which are different from the predefined locations on the surface and processing the surface in the vacuum environment, wherein the step of processing the surface comprises at least one of removing surface particles from the surface and depositing at least some of the ionized particles of the second material an the surface.

As, for example, an emissive layer of an organic light emitting device (OLED) typically consists of a matrix and a dopant material co-deposition of different materials is required and all materials must be ionized to prevent deposition onto undesired pixels. For this purpose two or more ion sources are used at the same time just as it is the case for a regular co-deposition. As a matter of course ions that supposed to be deposited onto the same pixel at the same time must also be of the same charge sign.

According to a preferred embodiment, the step of providing the micro field with the second field component comprises providing the second field component with a polarity which is one selected from a polarity of the first field component and an opposite polarity which is opposite to the polarity of the first field component.

In another preferred embodiment, the step of providing the micro field comprises varying at least one of the first and second field components according to an application mode.

In a preferred embodiment, the step of varying at least one of the first and second field components according to the application mode comprises correlating the application mode to an operation mode of at least one of a first source and a second source provided as sources of particles of the first material and the second material, respectively.

According to a further embodiment, at least one of the ionized particles of the first and second materials are deposited on the surface in a predefined multicolor pixel pattern. Taking a full color display as example, the task is to distribute the emitter molecules of three different colors, red, green and blue onto the associated sub-pixels of the display substrate. In this case the process can be described as follows: Firstly, organic molecules e.g. blue fluorescent molecules are ionized by a standard method. An energy filter or other means of ion manipulation may be included to purify the ion beam from fragmented and multiple charged molecules, and to tailor the deposition process, e.g. deposition rate or ion energy to the substrate requirements. Secondly, only electrodes of sub-pixels for e.g. blue color of the substrate are supplied with an electrostatic potential that is attractive to the generated ions. At the same time the sub-pixels for the other colors are either grounded or supplied with a repellent potential. Thus the blue fluorescent molecules are deposited solely onto the pixels for blue color. Then the same principle is utilized for the other colors as well.

In still a further embodiment, at least one of the first and second materials are provided as emitter material which in response to application of an electric voltage emit light.

According to a preferred embodiment, at least one of the first and second materials are provided as a material selected from the following group of materials: organic material, and metal.

In still a further embodiment, the step of providing the micro field in the micro environment of the surface comprises shaping the micro field by providing pre-patterned surface structure elements on the surface of the substrate.

In another preferred embodiment, at least one of the predefined locations and the additional predefined locations are generated by providing the pre-patterned surface structure elements on the surface of the substrate.

In a preferred embodiment, the step of providing pre-patterned surface structure elements on the surface of the substrate comprises exposing the substrate to at least one of an oxygen plasma and an inert gas plasma.

In still a further embodiment, the method further comprises a step of purifying at least one of the ionized particles of the first material and the ionized particles of the second material.

In another preferred embodiment, the step of providing ionized particles in the vacuum environment comprises a step of generating ionized particles of at least one of the first and second materials by field ionization of particles evaporated into the vacuum environment.

In still a further embodiment, the step of providing ionized particles in the vacuum environment comprises generating ionized particles of at least one of the first and second materials by electro spray ionization.

In a preferred embodiment, the step of providing ionized particles in the vacuum environment comprises generating at least one of ionized atoms and ionized molecules.

In still a further embodiment, the step of providing ionized particles in the vacuum environment comprises generating ionized particles of at least one of the first and second materials by electron impact ionization.

In a preferred embodiment, the step of processing the surface of the substrate comprises a step providing a thin layer on the surface of the substrate by depositing at least some of the ionized particles on the surface.

According to a further embodiment, the step of providing the thin layer on the surface of the substrate comprises a step of providing the thin layer with a thickness of 1µm or less.

According to a preferred embodiment, the thin layer is deposited in a device selected from the following group of devices: an organic light emitting device, an active matrix display, a passive matrix display, and an electronic device.

In case of active matrix displays, for example, a simple redesign of the substrate to connect all pixels of the same color on the frame with each other may be suitable. Additionally at least one electrical feedthrough to the outside of the vacuum chamber is required for control purposes. In a subsequent process step, that is standard to active matrix displays, the frame is removed. For passive matrix displays a similar approach may be appropriate. Alternatively both types of displays would have to be processed until a step where regular control cables are attached.

### Description of preferred embodiments of the invention

Following the invention will be described in further detail, by way of example, with reference to different embodiments. In the figures:
- Fig. 1A: shows a schematic representation of a time regime of a conventional deposition of a thin layer;
- Fig. 1B: shows a schematic representation of a time regime of a clocked deposition of a thin layer;
- Fig. 2A to 2C: show a schematic representation of short periods of an evaporation process onto a substrate surface;
- Fig. 3: shows a cross section of ion-traces guided by permanent toroid magnets;
- Fig. 4: shows a mass spectrum of a green emitting dopant molecule Ir(ppy)₃ by electrospray ionization, which indicates little fragmentation;
- Fig. 5: shows results of simplified ion optical simulations, wherein a material distribution on top of a grounded pixel at an initial ion energy of 10eV and a voltage of +10.1V applied to neighboring pixels (repellent potential) is depicted;
- Fig. 6: results of simplified ion optical simulations, wherein ion trajectories and equipotential lines of three pixels (left hand side) as well as a magnification of a center part for a pixel with attractive potential (right hand side) are depicted; and
- Fig. 7: shows a schematic representation of a deposition process for two different colors.

The method according to the invention uses field components of at least one of an electric and a magnetic field for guiding ionized particles / molecules (ions) to predefined areas on a surface of a substrate which is to be micro processed, wherein the ionized particles are provided by discharging particles from a material source. Preferred for mass production, in respect to costs the ionization of molecules is performed with no or little fragmentation. Field ionization of evaporated molecules by electron tunneling works well for small molecules. In comparison, electro spray ionization can even be applied to fragile molecules with negligible fragmentation (see Gross: "Mass Spectrometry" Springer Publishing Company, March 2004, ISBN: 3540407391). The above and other methods for ionization are known as such. Therefore, ionization needs not to be explained in further detail. For example, another method for ionization also known as such is electron impact ionization (see also Gross: "Mass Spectrometry" Springer Publishing Company, March 2004, ISBN: 3540407391).

In one embodiment, ions may be discharged from an ion source into the vacuum environment. According to another embodiment, particles of the material may be provided in the vacuum environment, for example, by evaporation. Following the particles are ionized and guided to the substrate in the vacuum environment. In the vicinity of the surface of the substrate, namely in a micro environment of the surface, the ionized particles interact with a micro field leading the ionized particles to predefined locations on the substrate.

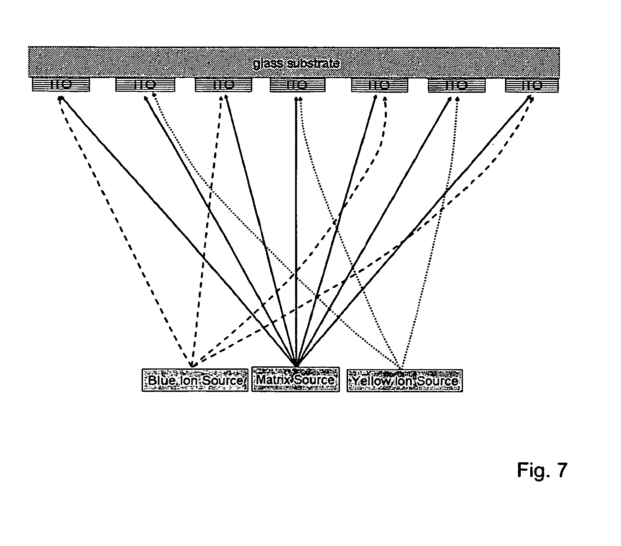

During the production of displays, emitter materials are deposited on a substrate. Emitter materials for different colors are used. Usually, the emitter materials are provided according to a pixel pattern structure with pixels for red, green and blue light. Such display is also referred to RGB display. Some displays generate white light or any color by only two types of pixel colors instead of three, e.g. blue and yellow emitters. In the display production process, a significant improvement regarding throughput can be achieved, if two colors are deposited at the same time rather than subsequently. To achieve this, positively charged ions of one kind of material and negatively charged ions of another kind of material are generated and can then be deposited onto differently charged pixels at the same time (see Fig. 7).

In case displays incorporating organic light emitting diodes (OLEDs) with doped emissive layers provided by co-evaporation of matrix material and emitter dopant material it is preferred to use the same matrix material for all emitter dopants in production. A so-called clocked deposition can lead to a factor three lower processing time for three colors.

The molecules of the matrix material of the layer are not ionized in a first embodiment and will be deposited by a standard thermal vacuum evaporation onto the whole substrate, no matter which potentials are applied on any kind of structures. The matrix will be evaporated at a constant rate, while the dopants which define the color of the OLED will be evaporated from ion-sources in a "pulsed" way, where the pulse period should be short compared to the time needed to deposit e.g. 1 nm.

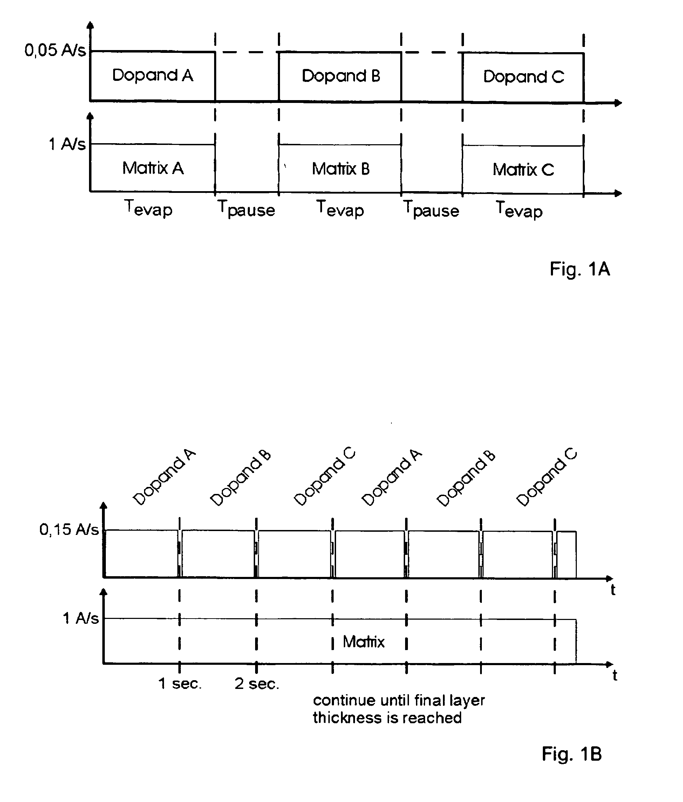

Fig. 1A shows a schematic representation of a time regime of a conventional deposition of a thin layer on a substrate. From evaporation sources a co-deposition of matrix materials A, B, C with a rate of 1Å/s (1 Å=0.1nm) and emitter dopant materials A, B, C with a rate of 0.05Å/s is performed with a doping ratio of 5vol%. The three colors of an RGB display are processed one after the other. Materials are evaporated during time periods Tₑᵥₐₚ, typically several minutes long, while evaporation is interrupted during tome periods Tₚₐᵤₛₑ, typically a few seconds long.

Fig. 1B shows a schematic representation of a time regime of a clocked deposition. A co-deposition with a doping ratio of 5vol% is performed. The three colors of an RGB display which are provided by the three emitter dopant materials A, B, C are processed in virtually one step. Compared to the conventional process in Fig. 1A the rate of the emitter dopant deposition has been increased by a factor of three to achieve the same doping ratio.

The clocking (pulsing) of the evaporation sources for the dopants can be achieved by e.g. switching of the deflection field in the energy filter of the ion sources. To guide to dopants to the right sub-pixels the applied potential of the pixels will be altered synchronously to the clocking of the dopants.

The potentials of each pixel have to be adjusted - either attractive or repellent to ions - for each period according to its desired color. To keep the ratio between matrix and dopant material constant in respect to the other method it is possible to increase the deposition rate of the dopant by a factor of three in case of three colors. Since the matrix-dopant ratio is typically 100:1 to 5:1 it is technically simple to multiply the dopant rate accordingly. Hence the total deposition time for RGB is only one-third of the previous method and therefore the throughput a factor of three higher. Additionally the matrix material mustn't be ionized, which is also a cost saving factor in production.

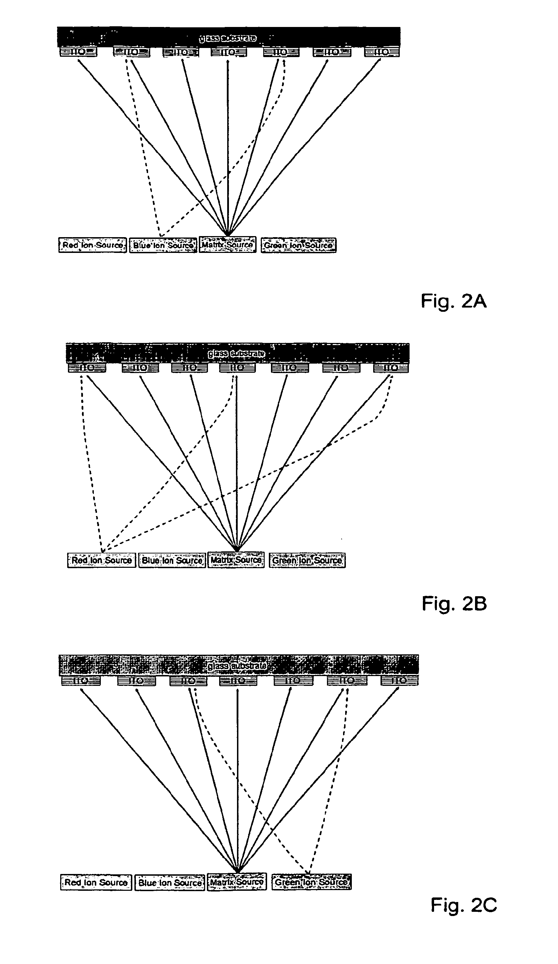

Fig. 2A, 2B, and 2C show three short periods of a clocked deposition onto a substrate surface.

After deposition of blue dopant material for a short time period in Fig. 2A, the evaporation continues with red dopant material for another short time period (Fig. 2B). Finally green dopant material is evaporated onto the substrate for a third short period (Fig. 2C). After the last step the cycle is repeated starting with blue again. For one period of time the potential of each pixel is adjusted according to its desired color. Firstly, the second and the fifth ITO-pixel from the left hand side in Fig. 2A are supplied with an attractive potential, the other ones with repellant potentials to deposit blue dopant molecules. Afterwards (Fig. 2B) the potentials of pixel one, four and seven from the left hand side are attractive to red dye and the other ones repellant. Finally, the potentials of the pixels are adjusted again in Fig. 2C to attract ions to the third and sixth pixel from the left hand side.

A further embodiment of the invention is a processing sequence wherein structuring by protective metal caps is performed. The method doesn't require the ionization of any organic material, but metal. The advantage is that a metal is easier to ionize than organic molecules and can not suffer any damage by the ionization process. The disadvantage is a more complicated fabrication.

In a first process step all pixels are covered with the same dopant material (or matrix / dopant mix). Subsequently an ionized metal is deposited only onto desired pixels analog to ionized organic materials. In a final process step the substrate surface is exposed to an oxygen plasma or inert gas plasma to remove organic materials on top of pixels without metal cover. All process steps have to be repeated for each color. Although the processing described in this embodiment is more extensive compared to previous ones, it has several advantages. Ion beam deposition of metals is a well known process in mass production. Metals can be ionized without fragmentation unlike molecules. Only one metal ion source is necessary whereas at least three are needed in case of ionized dopants. The remaining metal layer acts as electrical contact and is standard for all OLED devices.

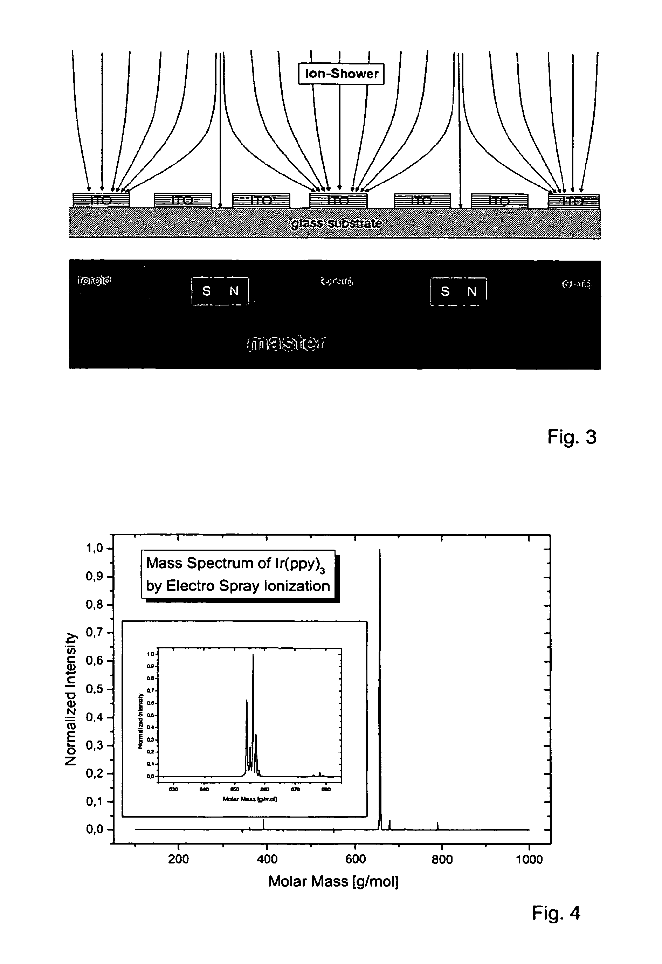

Referring to Fig. 3, instead of a pre-patterned substrate to generate attractive or repellent electrostatic fields on its surface, a "magneto static master" can be used. The master with its inherent magnetic fields is located directly underneath the substrate to focus the ion-shower into a desired pattern before impact on the substrate surface. All magnetic fields of the master can be generated by islands of permanent magnetic structures by utilizing MEMS (*"Micro Electro Mechanical Systems"*) technology. Alternatively electroplated micro-coils may serve as electrostatic magnets with controllable field strength.

The process may be repeated with another type of organic molecules by changing the position of the master in respect to the substrate to manufacture RGB lightings. Compared to the case without deflection master it neither requires electrical contacts to the substrate nor any conductive areas on a defined electrical potential on the substrate. To prevent charging effects and therefore non-uniform coating, it is beneficial to keep the substrate on ground potential. In general this embodiment of the invention can be used as versatile lithography tool for any kind of non-ferromagnetic substrates or deposited materials, e.g. silicon wafers and copper traces. It is independent of the pattern on the substrate and not limited to a specific deposition shape like the depicted circular pixels in the sketch. Furthermore the master can be reused without wear.

Referring to Fig. 4, an example of a mass spectrum of the green emitting dopant molecule Ir(ppy)₃ by electro spray ionization is shown, which indicates little fragmentation. The integrated intensity within the range of 653g/mol and 658g/mol (range with an intensity of≥1%) is 92%. Other peaks in the spectrum, e.g. at 679g/mol (sodium from solvent) are not necessarily caused by fragmented Ir(ppy)₃. All molecules related to these peaks would be sorted out anyhow due to subsequent energy filtering of the ionized material.

To achieve an adequate throughput for mass production a deposition rate of 0.1nm/s for a surface area of 0.25m² was assumed. Thus approximately 3.9x10¹⁶ molecules/s or an ion beam current of 6.2mA is required in case of Ir(ppy)₃, which can easily be achieved by standard ion beam deposition equipment. The mean free path of molecules in this case would be 47µm for an ion energy of 10eV in a vacuum chamber.

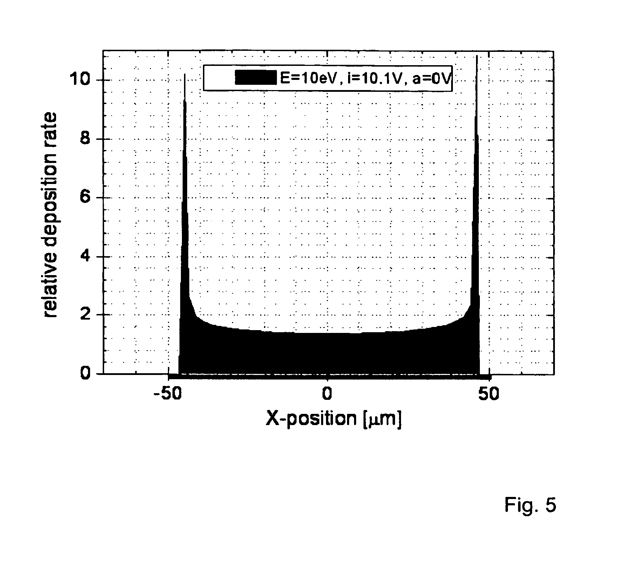

Referring to Fig. 5, results of simplified ion optical simulations are shown, wherein a material distribution on top of a grounded pixel (attractive potential) at an initial ion energy of 10eV and a voltage of +10.1 V applied to neighboring pixels (repellent potential) is depicted. The results show a high selectivity between pixels with a repellent and attractive potential. Many independent control parameters, e.g. initial ion energy, potential of pixels with a repellent potential, ion landing energy or deposition angle enable an optimization of material distribution within a pixel, especially at the corners. This is another significant advantage in respect to shadow masking.

In Fig. 5 the pixel is 100µm wide (x-direction) and has an infinite length to simplify the simulation. Neighboring pixels are spaced apart by 10µm and have the same size. Both peaks at the edges will be less pronounced in a reality, but the material will be rather spread around their maximum.

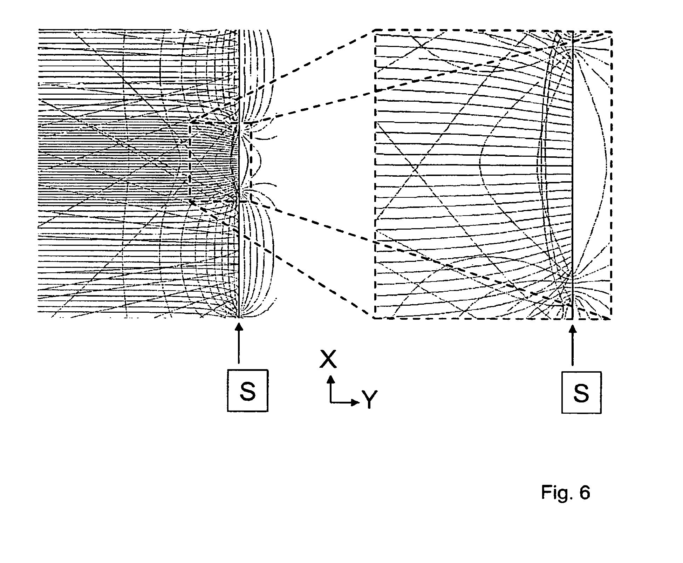

Fig. 6 shows ion trajectories (lines along x-axis) and equipotential lines (lines along y-axis) that generate the material distribution of Fig. 5. The bold line S refers to the substrate surface with three pixels. On the right hand side a magnification of a center part for a pixel with attractive potential is shown.

Ions of a uniform shower enter in straight lines from the left and fly to the pixel surface on the right hand side. Since the center pixel in Fig. 6 is attractive, all trajectories in this area end on its surface. The other trajectories on top and bottom of the graph change direction just above the pixel surfaces with repellent potential and continue to fly in roughly the opposite direction.

A small potential difference of 0.1 V is sufficient to prevent ions from landing on a pixel surface. However it has to be mentioned that an energy spread of the same magnitude appears for real ion sources. In a production environment the potential difference selection would be higher, e.g. 0.2V to accommodate the energy spread.

In principle one important factor for a controlled thin film fabrication of any kind of material is the deposition rate. Ion optics offers several methods to limit the rate in a simple manner, e.g. by modifying the extraction voltage of a plasma source.

For the previous case a positively charged ion has been assumed. However the same results can be obtained for negatively charged ions, if the repellent pixel voltage is modified from +10.1 V to -10.1 V.

As long as the setup is entirely electrostatic and ion-ion interactions are not considered the ion mass is irrelevant for the simulations above. This means the ion trajectories remain the same for all types of charged species like molecules or atoms. Space charge effects will alter the distribution of equipotential lines for high ion currents and result in ion-ion interactions. Nevertheless the simplification above is a good approximation for the selected parameters and typical for ion-optical simulations with a high confidence regarding the results.

The method for depositing a thin layer with a thickness of about 1 µm or less is described for layers comprising emitter material(s). In the same way ionized particles of a electric dopant material can be deposited in a thin layer, for example, in an electron or hole transport layer in an organic light emitting device. The dopant material F₄-TCNQ and matrix material ZnPc are examples for a hole transport layer and Bphen in combination with Cs, receptively, examples for an electron transport layer in an OLED device (Pfeiffer et al.: "Doped organic semiconductors: physics and application in light emitting diodes", Organic Electronics 4 (2003) p. 89-103).

Fig. 6 also shows an example for an electrostatic micro field. The equipotential lines become almost parallel to the x-axis in a distance of 100µm to the substrate surface, which indicates a diminishing influence of the micro field. It obviously shows that the means to generate the field, pixels on a controlled potential in Fig. 6, must be within the effective range of the field, too. The previous conclusions can be generalized to all electrostatic as well as magnetostatic cases. However, only cases for patterns with a pitch in the order or less than 1mm may be of interest for micro-structuring.

In another embodiment, a shower of ionized atoms, e.g. Gallium is utilized to remove already deposited molecules on top of pixels that are supplied with an attractive potential whereas other pixels are repellant to the ions. This embodiment doesn't require the ionization of organic molecules. It is similar to conventional material ablation by a focused ion beam (FIB). In contrary to FIB the ions are focused by an electrostatic or magnetostatic field that is generated by a pre-defined pattern on a substrate or a master underneath rather than by ion-optical elements of the equipment. Furthermore FIB requires alignment of the beam in respect to the substrate to enable ablation of molecules at specific locations. Since FIB is a scanning method the throughput is rather low compared to sputtering by an ion shower, which removes molecules on top of all desired pixels at the same time. Compared to the previously described embodiment where the whole OLED structure is removed by an oxygen plasma or inert gas plasma, only one layer, which is the emitter layer, has to be removed. Thus all other layers must be deposited only once for an OLED device with as many colors as desired.

## Claims

1. A method for surface processing in a vacuum environment by depositing an organic material with spatial separation on a substrate, the method comprising the following steps:
- providing a substrate in the vacuum environment;
- providing ionized particles of a first material in the vacuum environment, wherein the first material is an organic material and wherein the particles of the first material arc generated by electro spray ionization;
- bringing the ionized particles of the first material into a micro environment of a surface of the substrate through the vacuum environment by applying a macro field to the ionized particles, wherein the macro field is used to accelerate used the ionized particles through the vacuum environment, thereby leading the ionized particles into the vicinity of the surface;
- providing, in addition to the macro field, a micro field **characterized by** a first field component in the micro environment of the surface, wherein the first field component comprises at least one of an electric field component and a magnetic field component and wherein an interaction between the first field component and the ionized particles of the first material is substantially limited to the micro environment of the surface; and
- guiding in the micro environment the ionized particles of the first material by the first field component to the surface of the substrate, thereby bringing the ionized particles of the first material into contact with the surface of the substrate at predefined locations on the surface and processing the surface in the vacuum environment, wherein the step of processing the surface comprises a step depositing at least some of the ionized particles of the first material on the surface with spatial separation.

2. Method according to claim 1, wherein the first field component comprises at least one of an attractive potential, a repellant potential, and a focusing magnetic force.

3. Method according to claim 1 or 2, wherein the step of providing the micro field further comprises providing the micro field by a micro field generator separated from the substrate.

4. Method according to claim 3, wherein the step of providing the micro field generator separated from the substrate comprises providing a magneto-static field generator.

5. Method according to claim 4, wherein the step of providing the magneto-static field generator comprises providing at least one of a permanent magnetic field generator and an electrically magnetized field generator.

6. Method according to one of the preceding claims, wherein the step of providing the micro field further comprises applying an electric voltage to at least one of the substrate and the field generator separated from the substrate.

7. Method according to one of the preceding claims, wherein the step of providing ionized particles of the first material comprises providing the first material as a dopant material and depositing the dopant material in a matrix material on the surface.

8. Method according to claim 7, wherein the step of depositing the dopant material in the matrix material comprises co-evaporating the dopant material and the matrix material.

9. Method according to claim 7 or 8, wherein the step of providing the dopant material comprises providing the dopant material as at least one of a dye material and an electric dopant material improving electric conductivity of the matrix material.

10. Method according to one of the preceding claims, the method further comprising:
- providing ionized particles of a second material in the vacuum environment;
- bringing the ionized particles of the second material into the micro environment of the surface of the substrate through the vacuum environment;
- providing the micro field with a second field component in the micro environment of the surface, wherein the second field component comprises at least one of an electric field component and a magnetic field component and wherein an interaction between the second field component and the ionized particles of the second material is limited to the micro environment of the surface; and
- guiding in the micro environment the ionized particles of the second material by the second field component to the surface of the substrate, thereby bringing the ionized particles of the second material into contact with the surface of the substrate in at least one of the predefined locations and additional predefined locations which are different from the predefined locations on the surface and processing the surface in the vacuum environment, wherein the step of processing the surface comprises at least one of removing surface particles from the surface and depositing at least some of the ionized particles of the second material on the surface.

11. Method according to claim 10, wherein the step of providing the micro field with the second field component comprises providing the second field component with a polarity which is one selected from a polarity of the first field component and an opposite polarity which is opposite to the polarity of the first field component.

12. Method according to one of the preceding claims, wherein the step of providing the micro field comprises varying at least one of the first and second field components according to an application mode.

13. Method according to claim 12, wherein the step of varying at least one of the first and second field components according to the application mode comprises correlating the application mode to an operation mode of at least one of a first source and a second source provided as sources of particles of the first material and the second material, respectively.

14. Method according to one of the preceding claims, wherein at least one of the ionized particles of the first and second materials are deposited on the surface in a predefined multicolor pixel pattern.

15. Method according to one of the preceding claims, wherein at least one of the first and second materials are provided as emitter material which in response to application of an electric voltage emit light.

16. Method according to one of the preceding claims, wherein the second materials is provided as a material selected from the following group of materials: organic material, and metal.

17. Method according to one of the preceding claims, wherein the step of providing the micro field in the micro environment of the surface comprises shaping the micro field by providing pre-patterned surface structure elements on the surface of the substrate.

18. Method according to claim 17, wherein at least one of the predefined locations and the additional predefined locations are generated by providing the prc-pattcmcd surface structure elements on the surface of the substrate.

19. Method according to claim 17 or 18, wherein the step of providing pre-patterned surface structure elements on the surface of the substrate comprises exposing the substrate to at least one of an oxygen plasma and an inert gas plasma.

20. Method according to one of the preceding claims, the method further comprising a step of purifying of at least one of the ionized particles of the first material and the ionized particles of the second material.

21. Method according to one of the preceding claims, wherein the step of providing ionized particles in the vacuum environment comprises a step of generating ionized particles of at least one of the first and second materials by field ionization of particles evaporated into the vacuum environment.

22. Method according to claim 10 and one of the claims 11 to 21, wherein the step of providing ionized particles in the vacuum environment comprises generating ionized particles of the second materials by electro spray ionization.

23. Method according to one of the preceding claims, wherein the step of providing ionized particles in the vacuum environment comprises generating at least one of ionized atoms and ionized molecules.

24. Method according to one of the preceding claims, wherein the step of providing ionized particles in the vacuum environment comprises generating ionized particles of at least one of the first and second materials by electron impact ionization.

25. Method according to one of the preceding claims, wherein the step of processing the surface of the substrate comprises a step providing a thin layer on the surface of the substrate by depositing at least some of the ionized particles on the surface.

26. Method according to claim 25, wherein the step of providing the thin layer on the surface of the substrate comprises a step of providing the thin layer with a thickness of 1µm or less.

27. Method according to claim 25 or 26, wherein the thin layer is deposited in a device selected from the following group of devices: an organic light emitting device, an active matrix display, a passive matrix display, and an electronic device.

## Patentansprüche

1. Verfahren zur Oberflächenbehandlung in einer Vakuumumgebung mittels Abscheidung eines organischen Materials mit räumlicher Trennung auf einem Substrat, wobei das Verfahren die folgenden Schritte umfasst:
- Bereitstellen eines Substrates in der Vakuumumgebung;
- Bereitstellen ionisierter Partikel eines ersten Materials in der Vakuumumgebung, wobei das erste Material ein organisches Material ist und die Partikel des ersten Materials mittels Elektrospray-lonisation erzeugt werden;
- Einbringen der ionisierten Partikeln des ersten Materials durch die Vakuumumgebung in eine Mikroumgebung einer Oberfläche des Substrates mittels Anlegen eines Makrofeldes an die ionisierten Partikeln, wobei das Makrofeld verwendet wird um die ionisierten Partikeln durch die Vakuumumgebung zu beschleunigen und damit die ionisierten Partikel in die Umgebung der Oberfläche zu führen,
- Bereitstellen eines zusätzlichen Mikrofeldes, wobei das Mikrofeld durch eine erste Feldkomponente in der Mikroungebung der Oberfläche charakterisiert ist und die erste Feldkomponente mindestens eine elektrische Feldkomponente und eine magnetische Feldkomponente aufweist, wobei eine Wechselwirkung zwischen der ersten Feldkoniponente und der ionisierten Partikel des ersten Materials im Wesentlichen auf die Mikroumgebung der Oberfläche begrenzt ist, und
- Führen der ionisierten Partikel des ersten Materials in der Mikroumgebung auf die Oberfläche des Substrates mittels der ersten Feldkomponente damit die ionisierten Partikel des ersten Materials in Kontakt mit der Oberfläche des Substrates an vordefinierten Positionen auf der Oberfläche treten und Behandlung der Oberfläche in der Vakuumumgebung, wobei die Behandlung der Oberfläche ein Abscheiden zumindest einiger der ionisierten Partikel des ersten Materials auf der Oberfläche mit räumlicher Trennung umfasst.

2. Verfahren nach Anspruch 1, wobei die erste Feldkomponente mindestens ein anziehendes Potential, ein abstoßende Potential und eine fokussierende Magnetkraft umfasst.

3. Verfahren nach Anspruch 1 oder 2, wobei das Bereitstellen des Mikrofeldes zusätzlich ein Bereitstellen eines mikrofelderzeugenden Mikrofeldgenerators getrennt vom Substrat umfasst.

4. Verfahren nach Anspruch 3, wobei das Bereitstellen des mikrofelderzeugenden Mikrofeldgenerators getrennt vom Substrat ein Bereitstellen eines magnetostatischen Feldgenerators umfasst.

5. Verfahren nach Anspruch 4, wobei das Bereitstellen eines magnetostatischen Fcldgcnerators ein Bereitstellen mindestens eines Permanentmagnetfeldgenerators und eines elektrisch magnetisierenden Feldgenerators umfasst.

6. Verfahren nach einem der vorangehenden Ansprüche, wobei das Bereitstellen eines Mikrofeldes ein Anlegen einer elektrischen Spannung zwischen Substrat und mindestens einem Feldgeneratoren getrennt vom Substrat umfasst.

7. Verfahren nach einem der vorangehenden Ansprüche, wobei das Bereitstellen ionisierter Partikel des ersten Materials ein Bereitstellen des ersten Materials als ein Dotierstoff und Abscheiden des Dotierstoffes in ein Matrixmaterial auf der Oberfläche umfasst.

8. Verfahren nach Anspruch 7, wobei das Abscheiden des Dotierstoffes in das Matrixmaterial eine Ko-Verdampfung des Dotierstoffes und des Matrixmaterials umfasst.

9. Verfahren nach Anspruch 7 oder 8, wobei das Bereitstellen des Dotierstoffes ein Bereitstellen eines Dotierstoffes als mindestens ein Farbstoff und ein elektrisches Dotiermaterial zur Verbesserung der elektrischen Leitfähigkeit des Matrixmaterials umfasst.

10. Verfahren nach einem der vorangehenden Ansprüche, wobei das Verfahren zusätzlich die folgenden Schritte umfasst:
- Bereitstellen ionisierter Partikel eines zweiten Materials in der Vakuumumgebung;
- Einbringen der ionisierten Partikeln des zweiten Materials durch die Vakuumumgebung in eine Mikroumgebung einer Oberfläche des Substrates;
- Bereitstellen eines Mikrofeldes mit einer zweiten Feldkomponente in der Mikroumgebung der Oberfläche, wobei die zweite Feldkomponente mindestens eine elektrische Feldkomponente und eine magnetische Feldkomponente aufweist, wobei eine Wechselwirkung zwischen der zweiten Feldkomponente und der ionisierten Partikel des zweiten Materials auf die Mikroumgebung der Oberfläche begrenzt ist, und
- Führen der ionisierten Partikel des zweiten Materials in der Mikroumgebung auf die Oberfläche des Substrates mittels der zweiten Feldkomponente damit die ionisierten Partikel des zweiten Materials in Kontakt mit der Oberfläche des Substrates an vordefinierten Positionen auf der Oberfläche treten und Behandlung der Oberfläche in der Vakuumumgebung, wobei die Behandlung der Oberfläche zumindest ein Entfernen von Oberfläehenpartikelen und ein Abscheiden zumindest einiger der ionisierten Partikel des zweiten Materials auf der Oberfläche umfasst.

11. Verfahren nach Anspruch 10, wobei das Bereitstellen eines Mikrofeldes mit der zweiten Feldkomponente eine Bereitstellen einer zweiten Feldkomponente mit einer Polarität umfasst, die ausgewählt aus einer Polarität der ersten Feldkomponente und einer der ersten Feldkompnnente entgegengesetzten Polarität ist.

12. Verfahren nach einem der vorangehenden Ansprüche, wobei das Bereitstellen der Mikroumgebung ein Variieren zumindest einer der ersten und zweiten Feldkomponente je nach Anwendungsmodus umfasst.

13. Verfahren nach Anspruch 12, wobei das Variieren der mindestens einen der ersten und zweiten Feldkomponente je nach Anwendungsmodus ein Korrelieren des Anwendungsmodus an eine Betriebsart der mindestens einen aus einer ersten und einer zweiten Quelle von Partikeln des ersten und des zweiten Materials entsprechend umfasst.

14. Verfahren nach einem der vorangehenden Ansprüche, wobei mindestens eines der ionisierten Partikel des ersten und zweiten Materials auf der Oberfläche in eine vordefinierte, mehrfarbige Pixel-Struktur abgeschieden wird.

15. Verfahren nach einem der vorangehenden Ansprüche, wobei zumindest eines des ersten und zweiten Materials als ein Emittermaterial bereitgestellt wird, das beim Anlegen einer elektrischen Spannung Licht emittiert.

16. Verfahren nach einem der vorangehenden Ansprüche, wobei das zweite Material aus der folgenden Gruppe von Materialien ausgewählt ist: organisches Material und Metall.

17. Verfahren nach einem der vorangehenden Ansprüche, wobei das Bereitstellen des Mikrofeldes in der Mikroumgebung der Oberfläche zumindest die Gestaltung der Mikroumgebung mittels Bereitstellen eines vorstrukturierten Oberflëchenelementes auf der Oberfläche des Substrates umfasst.

18. Verfahren nach Anspruch 17, wobei mindestens eine der vordefinierten Positionen und der weiteren vordefinierten Positionen mittels des vorstrukturiertcn Oberflächenstrukturelementes auf der Oberfläche des Substrates erzeugt werden.

19. Verfahren nach Anspruch 17 oder 18, wobei das Bereitstellen des vorstrukturierten Oberflächenstrukturelementes auf der Oberfläche des Substrates ein Aussetzen des Substrates mit mindestens einem Sauerstoff-Plasma und einem Inertgas-Plasma umfasst.

20. Verfahren nach einem der vorangehenden Ansprüche, wobei das Verfahren ein Reinigen von mindestens einem der ionisierten Partikel des ersten Materials und der ionisierten Partikel des zweiten Materials umfasst.

21. Verfahren nach einem der vorangehenden Ansprüche, wobei das Bereitstellen von ionisierten Partikeln in der Vakuumumgebung ein Erzeugen von ionisierten Partikeln von mindestens einem der ersten und zweiten Materialien mittels Feldionisation der verdampften Partikel in der Vakuumumgebung umfasst.

22. Verfahren nach Anspruch 10 und einem der Ansprüche 11 bis 21, wobei das Bereitstellen von ionisierten Partikeln in der Vakuumumgebung ein Erzeugen der ionisierten Partikeln des zweiten Materials mittels Elektrospray-Ionisation umfasst.

23. Verfahren nach einem der vorangehenden Ansprüche, wobei das Bereitstellen der ionisierten Partikel in der Vakuumumgebung mindestens ein Erzeugen von ionisierten Atomen oder ionisierten Molekülen umfasst.

24. Verfahren nach einem der vorangehenden Ansprüche, wobei das Bereitstellen der ionisierten Partikel in der Vakuumumgebung ein Erzeugen von ionisierten Partikeln des mindestens ersten oder zweiten Materials mittels Elektronenstoßionisation umfasst.

25. Verfahren nach einem der vorangehenden Ansprüche, wobei die Behandlung der Oberfläche des Substrates ein Herstellen einer dünnen Schicht auf der Oberfläche des Substrates mittels Abscheidung zumindest einiger der ionisierten Partikel auf der Oberfläche umfasst.

26. Verfahren nach Anspruch 25, wobei das Bereitstellen der dünnen Schicht auf der Oberfläche des Substrates ein Bereitstellen einer Dicke der dünnen Schicht von 1µm oder weniger umfasst.

27. Verfahren nach Anspruch 25 oder 26, wobei die dünne Schicht in ein Bauteil abgeschieden wird, das aus der folgenden Gruppe von Bauteilen ausgewählt ist: eine organisches lichtemittierendes Bauteil, ein Aktivmatrixdisplay, ein Passivmatrixdisplay und ein elektronisches Bauteil.

## Revendications

1. Procédé pour le traitement de surfaces dans un environnement sous vide, consistant à déposer une matière organique avec séparation spatiale sur un substrat, la méthode comprenant les étapes suivantes :
- mise à disposition d'un substrat dans l'environnemcnt sous vide ;
- mise à disposition de particules ionisées d'un premier matériau dans l'environnement sous vide, où le premier matériau est une matière organique et où les particules du premier matériau sont générées par ionisation par électronébulisation ;
- transfert des particules ionisées du premier matériau dans un microcenvironnement d'une surface du substrat à travers l'environnement sous vide, en appliquant un champ macro aux particules ionisées, où le champ macro est utilisé pour accélérer le passage des particules ionisées à travers l'environnement sous vide, guidant ainsi les particules ionisées dans le voisinage de la surface ;
- mise à disposition, en plus du champ macro, d'un champ micro **caractérisé par** un premier composant de champ dans le microenvironnement de la surface, ou le premier composant de champ comprend au moins l'un parmi un composant de champ électrique et un composant de champ magnétique, et où une interaction entre le premier composant de champ et les particules ionisées du premier matériau est substantiellement limitée au microenvironnement de la surface ; et
- guidage des particules ionisées du premier matériau dans le microenvironnement par le premier composant de champ vers la surface du substrat, mettant ainsi les particules ionisées du premier matériau en contact avec la surface du substrat à des endroits prédéfinis à la surface, et traitant ainsi la surface dans l'environnement sous vide, où l'étape de traitement de la surface comprend une étape de dépôt d'au moins une partie des particules ionisées du premier matériau sur la surface, avec séparation spatiale.

2. Procédé selon la revendication 1, dans lequel le premier composant de champ comprend au moins l'un parmi un potentiel attractif et un potentiel répulsif, et une force magnétique de focalisation.

3. Procédé selon la revendication 1 ou 2, dans lequel l'étape de mise à disposition du champ micro comprend en outre la mise à disposition du champ micro par un générateur de champ micro séparé du substrat.

4. Procédé selon la revendication 3, dans lequel l'étape de mise à disposition du générateur de champ micro séparé du substrat comprend la mise à disposition d'un générateur de champ magnétostatique.

5. Procédé selon la revendication 4, dans lequel l'étape de mise à disposition du générateur de champ magnétostatique comprend la mise à disposition d'au moins l'un parmi un générateur de champ magnétique permanent et un générateur de champ magnétique par l'électricité.

6. Procédé selon l'une des revendications précédentes, dans lequel l'étape de mise à disposition du champ micro comprend en outre l'application d'une tension électrique à au moins l'un parmi le substrat et le générateur de champ séparé du substrat.

7. Procédé selon l'une des revendications précédentes, dans lequel l'étape de mise à disposition des particules ionisées du premier matériau comprend la mise à disposition du premier matériau en tant que matériau dopant, et le dépôt du matériau dopant sur la surface, dans un matériau à matrice.

8. Procédé selon la revendication 7, dans lequel l'étape de dépôt du matériau dopant dans le matériau à matrice comprend l'évaporation simultanée du matériau dopant et du matériau à matrice.

9. Procédé selon la revendication 7 ou 8, dans lequel l'étape de mise à disposition du matériau dopant comprend la mise à disposition d'au moins un matériau dopant parmi un matériau de teinture et un matériau dopant électrique améliorant la conductivité électrique du matériau à matrice.

10. Procédé selon l'une des revendications précédentes, le procédé comprenant en outre :
- la mise à disposition de particules ionisées d'un deuxième matériau dans l'environnement sous vide ;
- le transfert des particules ionisées du deuxième matériau dans le microenvironnement de la surface du substrat à travers l'environnement sous vide ;
- la mise à disposition du champ micro avec un deuxième composant de champ dans le microenvironnement de la surface, où le deuxième composant de champ comprend au moins l'un parmi un composant de champ électrique et un composant de champ magnétique, et où une interaction entre le deuxième composant de champ et les particules ionisées du deuxième matériau est limitée au microenvironnement de la surface ; et
- le guidage des particules ionisées du deuxième matériau dans le microenvironnement par le deuxième composant de champ vers la surface du substrat, mettant ainsi les particules ionisées du deuxième matériau en contact avec la surface du substrat dans au moins l'un parmi les endroits prédéfinis et d'autres endroits prédéfinis différents des endroits prédéfinis sur la surface, et traitant ainsi la surface dans l'environnement sous vide, où l'étape de traitement de la surface comprend au moins l'un parmi le retrait des particules de la surface et le dépôt d'au moins une partie des particules ionisées du deuxième matériau sur la surface.

11. Procédé selon la revendication 10, dans lequel l'étape de mise à disposition du champ micro avec le deuxième composant de champ comprend la mise à disposition du deuxième composant de champ avec une polarité sélectionnée parmi une polarité du premier composant de champ et une polarité inverse, opposée à la polarité du premier composant de champ.

12. Procédé selon l'une des revendications précédentes, dans lequel l'étape de mise à disposition du champ micro comprend la variation d'au moins l'un parmi les premier et deuxième composants de champ, selon un mode d'application.

13. Procédé selon la revendication 12, dans lequel l'étape de variation d'au moins l'un parmi les premier et deuxième composants de champ selon le mode d'application comprend la corrélation entre le mode d'application et un mode de fonctionnement d'au moins l'une parmi une première source et une deuxième source fournies en tant que sources de particules du premier matériau et du deuxième matériau, respectivement.

14. Procédé selon l'une des revendications précédentes, dans lequel au moins les unes parmi les particules ionisées des premier et deuxième matériaux sont déposées sur la surface, selon un motif de pixels polychromes prédéfini.

15. Procédé selon l'une des revendications précédentes, dans lequel au moins l'un parmi les premier et deuxième matériaux est fourni en tant que matière émettrice, émettant une lumière en réponse à l'application d'une tension électrique.

16. Procédé selon l'une des revendications précédentes, dans lequel le deuxième matériau est fourni en tant que matériau sélectionné parmi le groupe de matériaux suivants : matière organique et métal.

17. Procédé selon l'une des revendications précédentes, dans lequel l'étape de mise à disposition du champ micro dans le microenvironnement de la surface comprend la mise en forme du champ micro, par l'apport d'éléments structurels de surface préformés à la surface du substrat.

18. Procédé selon la revendication 17, dans lequel au moins les uns parmi les endroits prédéfinis et les endroits prédéfinis supplémentaires sont générés par la disposition des éléments structurels de surface préformés sur la surface du substrat.

19. Procédé selon la revendication 17 ou 18, dans lequel l'étape de mise à disposition d'éléments structurels de surface préformés sur la surface du substrat comprend l'exposition du substrat à au moins l'un parmi un plasma d'oxygène et un plasma de gaz inerte.

20. Procédé selon l'une des revendications précédentes, dans lequel le procédé comprend en outre une étape de purification d'au moins les unes parmi les particules ionisées du premier matériau et les particules ionisées du deuxième matériau.

21. Procédé selon l'une des revendications précédentes, dans lequel l'étape de mise à disposition de particules ionisées dans l'environnement sous vide comprend une étape de génération de particules ionisées d'au moins l'un parmi les premier et deuxième matériaux, par ionisation de champ de particules évaporées dans l'environnement sous vide.

22. Procédé selon la revendication 10 et l'une des revendications 11 à 21, dans lequel l'étape de mise à disposition de particules ionisées dans l'environnement sous vide comprend la génération de particules ionisées du deuxième matériau par ionisation par électronébulisation.

23. Procédé selon l'une des revendications précédentes, dans lequel l'étape de mise à disposition de particules ionisées dans l'environnement sous vide comprend la génération d'au moins l'un parmi des atomes ionisés et des molécules ionisées.

24. Procédé selon l'une des revendications précédentes, dans lequel l'étape de mise à disposition de particules ionisées dans l'environnement sous vide comprend la génération de particules ionisées d'au moins l'un parmi les premier et deuxième matériaux par ionisation par impact d'électrons.

25. Procédé selon l'une des revendications précédentes, dans lequel l'étape de traitement de la surface du substrat comprend une étape consistant à disposer une fine couche sur la surface du substrat, en déposant au moins une partie des particules ionisées sur la surface.

26. Procédé selon l'une des revendications précédentes, dans lequel l'étape de dépôt d'une fine couche sur la surface du substrat comprend une étape de dépôt d'une fine couche avec une épaisseur de 1 µm ou moins.

27. Procédé selon la revendication 25 ou 26, dans lequel la fine couche est déposée dans un dispositif sélectionné parmi le groupe de dispositifs suivants : un dispositif émetteur de lumière organique, un écran à matrice active, un écran à matrice passive, et un dispositif électronique.
